# EUROPÄISCHE PATENTSCHRIFT

(11) **EP 3 000 168 B1**
(45) Veröffentlichungstag und Bekanntmachung des Hinweises auf die Patenterteilung: **06.11.2019**
(21) Anmeldenummer: 13739378.1
(22) Anmeldetag: 08.07.2013
(51) Int. Cl.: H02M 7/00, H02M 7/483, H05K 7/20

(54) **MEHRSTUFENUMRICHTER**
MULTILEVEL CONVERTER
CONVERTISSEUR ELECTRONIQUE A PLUSIEUR NIVEAUX

(43) Veröffentlichungstag der Anmeldung: 30.03.2016
(73) Patentinhaber: Siemens Aktiengesellschaft, 80333 München (DE)
(72) Erfinder: BUSCHENDORF, Martin, 01159 Dresden (DE); EULER, Ingo, 91056 Erlangen (DE); PIESCHEL, Martin, 90473 Nürnberg (DE); ZENKNER, Andreas, 90587 Obermichelbach (DE)
(86) Internationale Anmeldenummer: PCT/EP2013/064379
(87) Internationale Veröffentlichungsnummer: WO 2015/003734

(56) Entgegenhaltungen:
- EP-A1- 2 369 624
- WO-A1-2013/000512
- DE-C1- 19 635 582
- US-A1- 2007 181 908
- US-A1- 2013 003 305
- A. LESNICAR; R. MARQUARDT: "An Innovative Modular Multilevel Converter Topology Suitable for Wide Power Range", 2003 IEEE BOLOGNA POWER TECH CONFERENCE, 23. Juni 2003 (2003-06-23), XP002723329, in der Anmeldung erwähnt

## Beschreibung

Die Erfindung bezieht sich auf einen Multilevelumrichter mit mindestens zwei in Reihe geschalteten Submodulen, wobei jedes Submodul jeweils mindestens zwei Schalter und einen Kondensator sowie zwei stromtragende äußere Modulanschlüsse aufweist.

Ein derartiger Multilevelumrichter ist beispielsweise aus der Druckschrift "An -Innovative Modular Multilevel Converter Topology Suitable for Wide Power Range" (A. Lesnicar und R. Marquardt, 2003 IEEE Bologna Power Tech Conference, 23.-26. Juni 2003, Bologna, Italien) bekannt. Bei diesem vorbekannten Multilevelumrichter handelt es sich um eine sogenannte Marquardt-Umrichteranordnung, die zumindest zwei parallel geschaltete Reihenschaltungen umfasst. Jede der parallel geschalteten Reihenschaltungen umfasst jeweils mindestens zwei in Reihe geschaltete Submodule, die jeweils mindestens zwei Schalter und einen Kondensator umfassen. Durch eine geeignete Ansteuerung der Schalter lässt sich das Spannungsniveau am Ausgang des Multilevelumrichters gezielt einstellen.

Bei modularen Multilevelumrichtern werden die einzelnen Submodule derzeit elektrisch isoliert zueinander angeordnet. Aufgrund der elektrischen Isolation können die beim Betrieb der Submodule auftretenden Stromkräfte erhebliche mechanische Schwingungen hervorrufen, welche die Submodule als solche sowie die mit ihnen verbundenen Bauteile mechanisch erheblich belasten und zu vorzeitiger Alterung führen können. Um das Problem der auftretenden Schwingungen in den Griff zu bekommen, werden bei Multilevelumrichtern heutzutage zusätzliche mechanische Dämpfungseinrichtungen eingesetzt; diese führen jedoch zu einem erheblichen Zusatzgewicht und können unter Umständen die Isolationsfestigkeit beeinträchtigen.

In der US 2013/0003305 A1 ist ein elektronisches Bauelement offenbart, bei dem ein Chip mit einem Kühlkörper mechanisch verbunden ist. Der Kühlkörper ist mit einem Anschluss des elektronischen Bauelementes elektrisch verbunden, so dass der Kühlkörper ebenfalls als Anschluss des Bauelementes dient.

Der Erfindung liegt demgemäß die Aufgabe zugrunde, einen Multilevelumrichter anzugeben, bei dem die beschriebene Schwingungsproblematik besser als bisher gelöst wird.

Diese Aufgabe wird erfindungsgemäß durch einen Multilevelumrichter mit den Merkmalen gemäß Patentanspruch 1 gelöst. Vorteilhafte Ausgestaltungen des erfindungsgemäßen Multilevelumrichters sind in Unteransprüchen angegeben.

Danach ist erfindungsgemäß vorgesehen, dass mindestens ein Submodul mindestens einen außenliegenden Kühlkörper aufweist, der als stromtragender äußerer Modulanschluss dient, wobei mindestens zwei benachbarte Submodule jeweils mindestens einen Kühlkörper aufweisen, der einen der stromtragenden äußeren Modulanschlüsse des jeweiligen Submoduls bildet und an dem zumindest einer der Schalter des jeweiligen Submoduls zur Kühlung innenwandseitig montiert ist, und die Kühlkörper der mindestens zwei benachbarten Submodule außenwandseitig derart aneinander anliegen, dass deren Kühlkörper und damit die durch diese Kühlkörper gebildeten stromtragenden äußeren Modulanschlüsse elektrisch miteinander verbunden sind.

Ein wesentlicher Vorteil des erfindungsgemäßen Submoduls ist darin zu sehen, dass zumindest ein Kühlkörper, der zur Kühlung von Komponenten des Submoduls dient, gleichzeitig auch die Funktion eines stromtragenden äußeren Modulanschlusses wahrnimmt. Dies ermöglicht es beispielsweise, Submodule miteinander dadurch zu kontaktieren, dass die Kühlkörper benachbarter Submodule aneinandergesetzt und miteinander in Verbindung gebracht werden. Ein Aneinandersetzen von Submodulen über die Kühlkörper und die gleichzeitige Nutzung der Kühlkörper als äußere stromtragende Modulanschlüsse ermöglicht es wiederum, die Submodule schwingungsfrei oder zumindest schwingungsarm zu fixieren, so dass während des Betriebs der Submodule bzw. während des Betriebs des Multilevelumrichters die Gefahr allzu großer mechanischer Schwingungen reduziert wird.

Gemäß einer besonders bevorzugten Ausgestaltung des Multilevelumrichters ist vorgesehen, dass der außenliegende Kühlkörper eine Außenwand des Submoduls bildet und an der Innenseite des Kühlkörpers zumindest einer der Schalter des jeweiligen Submoduls zur Kühlung montiert und mit einem Schalteranschluss an den Kühlkörper elektrisch angeschlossen ist.

Die Submodule können beispielsweise jeweils zwei Kühlkörper aufweisen. In einem solchen Fall wird es als vorteilhaft angesehen, wenn zumindest zwei Submodule jeweils einen ersten und einen zweiten außenliegende Kühlkörper aufweisen, von denen der erste Kühlkörper als erster stromtragender äußerer Modulanschluss und der zweite Kühlkörper als zweiter stromtragender äußerer Modulanschluss des jeweiligen Submoduls dient, und der erste stromtragende äußere Modulanschluss eines der zumindest zwei Submodule mit dem zweiten stromtragenden äußeren Modulanschluss eines anderen der zumindest zwei Submodule elektrisch verbunden ist, und zwar durch mechanischen Kontakt zwischen dem ersten Kühlkörper des einen der zumindest zwei Submodule und dem zweiten Kühlkörper des anderen der zumindest zwei Submodule.

Die Schalter der Submodule können elektrisch beispielsweise sogenannte H-Brücken bilden. Demgemäß wird es als vorteilhaft angesehen, wenn zumindest eines der Submodule eine erste Reihenschaltung, eine zweite Reihenschaltung und einen parallel zu den beiden Reihenschaltungen liegenden Kondensator aufweist, wobei die erste Reihenschaltung und die zweite Reihenschaltung jeweils zwei elektrisch in Reihe liegende Schalter umfassen, die erste Reihenschaltung an einem ersten Kühlkörper des Submoduls und die zweite Reihenschaltung an einem zweiten Kühlkörper des Submoduls angebracht ist, ein Mittenanschluss der ersten Reihenschaltung elektrisch mit dem ersten Kühlkörper verbunden ist und den ersten stromtragenden Modulanschluss des Submoduls bildet und ein Mittenanschluss der zweiten Reihenschaltung elektrisch mit dem zweiten Kühlkörper verbunden ist und den zweiten stromtragenden Modulanschluss des Submoduls bildet.

Besonders vorteilhaft ist es, wenn zwei oder mehr Submodule jeweils eine erste Reihenschaltung und eine zweite Reihenschaltung mit jeweils zwei in Reihe liegenden Schaltern und jeweils einen parallel zu den beiden Reihenschaltungen liegenden Kondensator aufweisen, die erste Reihenschaltung an einem ersten Kühlkörper des jeweiligen Submoduls und die zweite Reihenschaltung an einem zweiten Kühlkörper des jeweiligen Submoduls angebracht ist, ein Mittenanschluss der ersten Reihenschaltung jeweils elektrisch mit dem ersten Kühlkörper des jeweiligen Submoduls verbunden ist und den ersten stromtragenden Modulanschluss des jeweiligen Submoduls bildet, ein Mittenanschluss der zweiten Reihenschaltung jeweils elektrisch mit dem zweiten Kühlkörper des jeweiligen Submoduls verbunden ist und den zweiten stromtragenden Modulanschluss des jeweiligen Submoduls bildet, und die Submodule derart paarweise aneinander anliegen, dass der erste Kühlkörper eines der Submodule an dem zweiten Kühlkörper eines benachbarten Submoduls anliegt und mit diesem thermisch und elektrisch leitend verbunden ist.

Anstelle von elektrischen H-Brücken können die Transistoren der Submodule elektrisch auch sogenannte Halbbrücken bilden. Demgemäß wird es gemäß einer anderen Ausgestaltung als vorteilhaft angesehen, wenn zumindest eines der Submodule ein Halbbrückenmodul ist, das einen ersten Schalter und einen zweiten Schalter aufweist, wobei der zweite Schalter mit dem Kondensator des Halbbrückenmoduls elektrisch in Reihe liegt und der erste Schalter zu dieser Reihenschaltung parallel liegt, und einer der beiden Schalteranschlüsse des ersten Schalters mit dem Kühlkörper oder einem der Kühlkörper des Halbbrückenmoduls verbunden ist und einen der beiden stromtragenden äußeren Modulanschlüsse des Halbbrückenmoduls bildet.

Im Falle von H-Brücken-Submodulen ist es besonders vorteilhaft, wenn der Multilevelumrichter zumindest zwei Halbbrückenmodule aufweist, der erste Schalter der zumindest zwei Halbbrückenmodule mit einem ersten Kühlkörper des jeweiligen Halbbrückenmoduls und der zweite Schalter der zumindest zwei Halbbrückenmoduls mit einem zweiten Kühlkörper des jeweiligen Halbbrückenmodule verbunden ist, einer der beiden Schalteranschlüsse des ersten Schalters der zumindest zwei Halbbrückenmodule elektrisch mit dem ersten Kühlkörper des jeweiligen Halbbrückenmoduls verbunden ist und den ersten stromtragenden Modulanschluss des jeweiligen Halbbrückenmoduls bildet, der andere der beiden Schalteranschlüsse des ersten Schalters der zumindest zwei Halbbrückenmodule elektrisch mit dem zweiten Kühlkörper des jeweiligen Halbbrückenmoduls verbunden ist und den zweiten stromtragenden Modulanschluss des jeweiligen Halbbrückenmoduls bildet und die zumindest zwei Halbbrückenmodule paarweise derart aneinander anliegen, dass der erste Kühlkörper eines der zumindest zwei Halbbrückenmodule an dem zweiten Kühlkörper eines anderen der zumindest zwei Halbbrückenmodule anliegt und mit diesem elektrisch verbunden ist.

Mit Blick auf ein einfaches Aneinandersetzen von Submodulen wird es als vorteilhaft angesehen, wenn der erste und der zweite Kühlkörper zumindest zweier Submodule parallel zueinander angeordnet sind und stromtragende äußere Modulanschlussplatten bilden und die mindestens zwei Schalter des jeweiligen Submoduls räumlich in dem Bereich zwischen den zwei Modulanschlussplatten des jeweiligen Submoduls liegen.

Mit Blick auf eine feste Verbindung benachbarter Submodule ist es vorteilhaft, wenn eine Spanneinrichtung vorhanden ist, die den ersten Kühlkörper mindestens eines der Submodule auf einen zweiten Kühlkörper eines benachbarten Submoduls presst.

Weist ein Submodul lediglich einen Kühlkörper auf, so kann ein anderer stromtragender äußerer Modulanschluss des Submoduls durch eine Elektrodenplatte gebildet werden. Demgemäß wird es als vorteilhaft angesehen, wenn zumindest eines der Submodule einen Kühlkörper aufweist, an dem die Schalter des jeweiligen Schaltmoduls montiert sind, und der Kühlkörper einen ersten stromtragenden äußeren Modulanschluss des Submoduls bildet, und das Submodul eine Elektrodenplatte aufweist, die beabstandet zu dem Kühlkörper des Submoduls angeordnet ist und einen zweiten stromtragenden äußeren Modulanschluss des Submoduls bildet.

Beispielsweise kann vorgesehen sein, dass zumindest zwei Submodule jeweils einen Kühlkörper aufweisen, an dem die Schalter des jeweiligen Schaltmoduls montiert sind, und der Kühlkörper einen ersten stromtragenden äußeren Modulanschluss des jeweiligen Submoduls bildet, die zumindest zwei Submodule jeweils eine Elektrodenplatte aufweisen, die beabstandet zu dem Kühlkörper des jeweiligen Submoduls angeordnet ist und einen zweiten stromtragenden äußeren Modulanschluss des jeweiligen Submoduls bildet, und der erste stromtragende äußere Modulanschluss eines der zumindest zwei Submodule mit dem zweiten stromtragenden äußeren Modulanschluss eines anderen der zumindest zwei Submodule elektrisch verbunden ist, und zwar durch mechanischen Kontakt zwischen dem Kühlkörper des einen der zumindest zwei Submodule mit der Elektrodenplatte des anderen der zumindest zwei Submodule.

Vorteilhaft ist es, wenn der Kühlkörper und die Elektrodenplatte bei den zumindest zwei Submodulen jeweils parallel zueinander angeordnet sind und stromtragende äußere Modulanschlussplatten des jeweiligen Submoduls bilden und die mindestens zwei Schalter eines jeden der zumindest zwei Submodule jeweils räumlich in dem Bereich zwischen den beiden stromtragenden äußeren Modulanschlussplatten liegen.

Vorzugsweise ist eine Spanneinrichtung vorhanden, die den Kühlkörper mindestens eines der Submodule auf eine Elektrodenplatte eines benachbarten Submoduls presst.

Die Erfindung bezieht sich darüber hinaus auf ein Submodul für einen Multilevelumrichter, wie er oben beschrieben worden ist. Erfindungsgemäß ist bezüglich eines solchen Submoduls vorgesehen, dass mindestens ein außenliegender Kühlkörper des Submoduls als stromtragender äußerer Modulanschluss dient.

Bezüglich der Vorteile des erfindungsgemäßen Submoduls sei auf die obigen Ausführungen im Zusammenhang mit dem erfindungsgemäßen Multilevelumrichter verwiesen, da die Vorteile des Multilevelumrichters denen des Submoduls im Wesentlichen entsprechen.

Die Erfindung wird nachfolgend anhand von Ausführungsbeispielen näher erläutert; dabei zeigen beispielhaft:
- Figur 1: ein Ausführungsbeispiel für einen dreiphasigen Multilevelumrichter, der mit einer Vielzahl an Submodulen ausgestattet ist,
- Figur 2: ein Ausführungsbeispiel für ein Submodul, das bei dem Multilevelumrichter gemäß Figur 1 oder einem anderen Multilevelumrichter eingesetzt werden kann und mit zwei stromtragenden Kühlkörpern ausgestattet ist,
- Figur 3: den mechanischen Aufbau des Submoduls gemäß Figur 2 in einer dreidimensionalen Sicht schräg von der Seite,
- Figur 4: beispielhaft die Bildung einer Submodulgruppe mit den Submodulen gemäß den Figuren 2 und 3 in einer Sicht von oben,
- Figur 5: die Submodulgruppe gemäß Figur 4 in einer Sicht von der Seite,
- Figur 6: ein weiteres Ausführungsbeispiel für ein Submodul, das bei dem Multilevelumrichter gemäß Figur 1 oder einem anderen Multilevelumrichter eingesetzt werden kann und zwei stromtragende Kühlkörper aufweist,
- Figur 7: ein Ausführungsbeispiel für ein Submodul, das bei dem Multilevelumrichter gemäß Figur 1 oder einem anderen Multilevelumrichter eingesetzt werden kann und bei dem ein stromtragender äußerer Modulanschluss durch einen Kühlkörper des Submoduls und der andere stromtragende äußere Modulanschluss durch eine Elektrodenplatte gebildet ist,
- Figur 8: den mechanischen Aufbau des Submoduls gemäß Figur 7 in einer dreidimensionalen Sicht schräg von der Seite,
- Figur 9: die Bildung einer Submodulgruppe mit den Submodulen gemäß den Figuren 7 und 8 in einer Sicht von oben,
- Figur 10: die Submodulgruppe gemäß Figur 9 in einer seitlichen Ansicht und
- Figur 11: ein weiteres Ausführungsbeispiel für ein Submodul, das bei dem Multilevelumrichter gemäß Figur 1 oder einem anderen Multilevelumrichter eingesetzt werden kann und bei dem ein stromtragender äußerer Modulanschluss durch einen Kühlkörper des Submoduls und ein weiterer stromtragender äußerer Modulanschluss durch eine Elektrodenplatte gebildet ist.

In den Figuren werden der Übersicht halber für identische oder vergleichbare Komponenten stets dieselben Bezugszeichen verwendet.

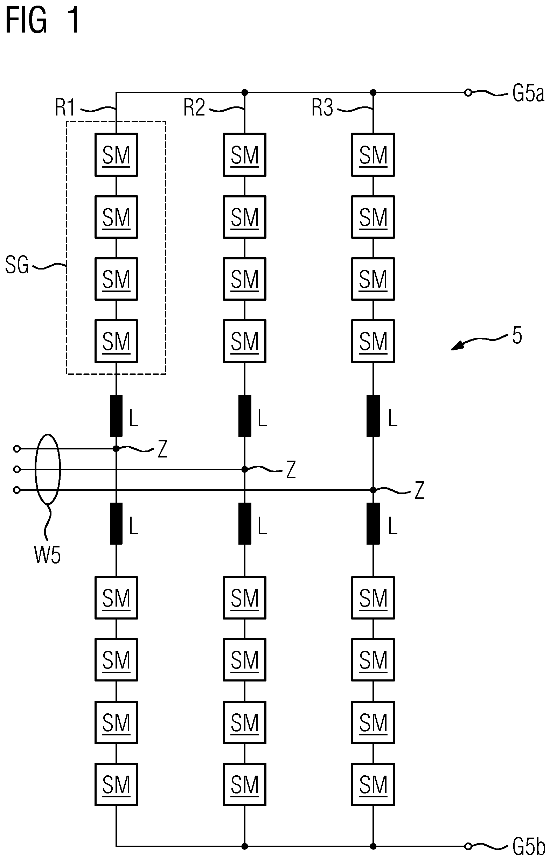

In der Figur 1 ist ein Ausführungsbeispiel für einen dreiphasigen Multilevelumrichter 5 gezeigt. Dieser umfasst Wechselspannungsanschlüsse W5 zum Ein- oder Ausspeisen von Wechselstrom sowie zwei Gleichspannungsanschlüsse G5a und G5b, an denen ein Gleichstrom oder ein zeitlich variabler Gleichstrom eingespeist oder entnommen werden. Die Richtung des Energieflusses und der zeitliche Verlauf der Ausgangsspannung, sei es an den Wechselspannungsanschlüssen W5 oder den Gleichspannungsanschlüssen G5a und G5b, hängt von der Ansteuerung von Submodulen SM ab, die in Reihenschaltungen R1, R2 und R3 in Reihe geschaltet sind. Eine solche Ansteuerung kann von einer zentralen Steuereinrichtung übernommen werden, die der Übersicht halber in der Figur 1 nicht gezeigt ist.

Jede der drei Reihenschaltungen R1, R2 und R3 ist bei dem Ausführungsbeispiel gemäß Figur 1 jeweils mit acht in Reihe geschalteten Submodulen SM sowie zwei Induktivitäten L ausgestattet. Jeweils zwischen den zwei Induktivitäten L befindet sich ein Zwischenanschluss Z, der potentialmäßig zwischen den in der Figur 1 oberen vier Teilmodulen und den in Figur 1 unteren vier Teilmodulen liegt und einen der drei Wechselspannungsanschlüsse W5 des Multilevelumrichters 10 bildet.

Jeweils vier Submodule bilden bei dem Multilevelumrichter 5 gemäß Figur 1 jeweils eine Submodulgruppe SG, bei der die Submodule SM mechanisch aneinander liegen und vorzugsweise mittels einer Spanneinrichtung aufeinander gepresst sind.

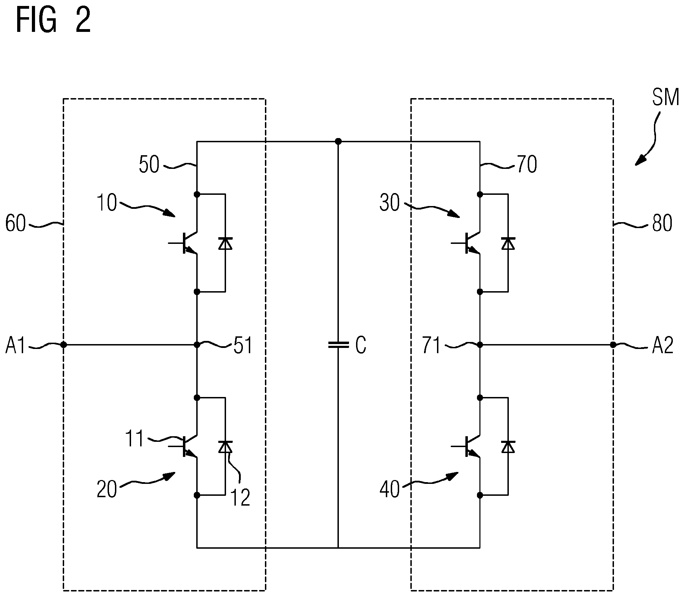

Die Figur 2 zeigt ein Ausführungsbeispiel für ein Submodul SM, das bei dem Multilevelumrichter 5 gemäß Figur 1 oder einem anderen Multilevelumrichter eingesetzt werden kann. Das Submodul SM weist vier Schalter 10, 20, 30 und 40 auf, die jeweils durch eine schaltende Halbleiterkomponente 11, beispielsweise einen Transistor oder dergleichen, sowie eine parallel geschaltete Diode 12 gebildet sein können.

Die beiden in der Figur 2 links angeordneten Schalter 10 und 20 sind elektrisch in Reihe geschaltet und bilden eine Reihenschaltung 50, die auf einem ersten Kühlkörper 60 des Submoduls SM angeordnet ist. Die Schalter 10 und 20 der Reihenschaltung 50 werden also durch den ersten Kühlkörper 60 gekühlt.

Der erste Kühlkörper 60 hat bei dem Submodul SM eine weitere Funktion, nämlich die Funktion eines stromtragenden Modulanschlusses A1 des Submoduls SM. Hierzu ist ein Mittenanschluss 51 der Reihenschaltung 50, der mit jeweils einem der Schalteranschlüsse der beiden Schalter 10 und 20 verbunden ist, elektrisch mit dem ersten Kühlkörper 60 verbunden. Eine Kontaktierung des Mittenanschlusses 51 der Reihenschaltung 50 bzw. eine elektrische Kontaktierung der Schalter 10 und 20 kann somit durch ein elektrisches Kontaktieren des ersten Kühlkörpers 60 erfolgen.

Die beiden Schalter 30 und 40 bilden ebenfalls eine Reihenschaltung, die in der Figur 2 mit dem Bezugszeichen 70 gekennzeichnet ist. Die Reihenschaltung 70 bzw. die beiden Schalter 30 und 40 sind auf einem zweiten Kühlkörper 80 angeordnet, der die beiden Schalter 30 und 40 während des Betriebs des Submoduls SM kühlt. Eine weitere Funktion des zweiten Kühlkörpers 80 besteht darin, einen stromtragenden Modulanschluss A2 des Submoduls SM zu bilden. Zu diesem Zweck ist ein Mittenanschluss 71 der Reihenschaltung 70 elektrisch mit dem Kühlkörper 80 verbunden.

Ein Kondensator C, der elektrisch parallel zu den beiden Reihenschaltungen 50 und 70 geschaltet ist, ist elektrisch von den beiden Kühlkörpern 60 und 80 getrennt.

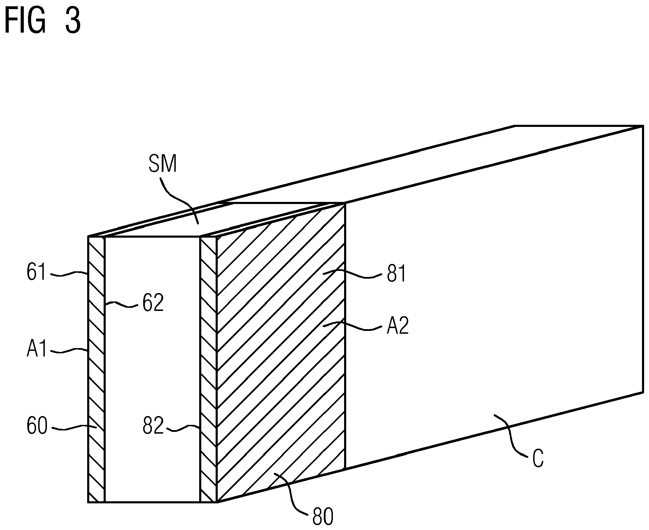

Die Figur 3 zeigt den mechanischen Aufbau des Submoduls SM gemäß Figur 2 in einer dreidimensionalen Sicht schräg von der Seite. Man erkennt die beiden außen liegenden Kühlkörper 60 und 80, die die stromtragenden äußeren Modulanschlüsse A1 und A2 in Form von Modulanschlussplatten bilden. Um ein Aneinandersetzen mehrerer Submodule SM zu ermöglichen, sind die Kühlkörper 60 und 80 außenwandseitig vorzugsweise plan sowie parallel, so dass eine Mehrzahl an Submodulen SM unter Bildung einer Submodulgruppe aneinandergesetzt werden kann. Die beiden vorzugsweise außen planen und vorzugsweise parallel zueinander angeordneten Außenwände der beiden Kühlkörper 60 und 80 sind in der Figur 3 mit den Bezugszeichen 61 und 81 gekennzeichnet.

Die Reihenschaltungen 50 und 70 mit den Schaltern 10, 20, 30 und 40 des Submoduls SM (vgl. Figur 2) sind vorzugsweise auf den Innenseiten 62 und 82 der beiden Kühlkörper 60 und 80 angeordnet. Bei dem Ausführungsbeispiel gemäß den Figuren 2 und 3 ist die Reihenschaltung 50 mit den Schaltern 10 und 20 auf der Innenseite 62 des Kühlkörpers 60 und die Reihenschaltung 70 mit den beiden Schaltern 30 und 40 auf der Innenseite 82 des Kühlkörpers 80 montiert. Der Kondensator C befindet sich beispielsweise außerhalb des Kühlkörperbereichs.

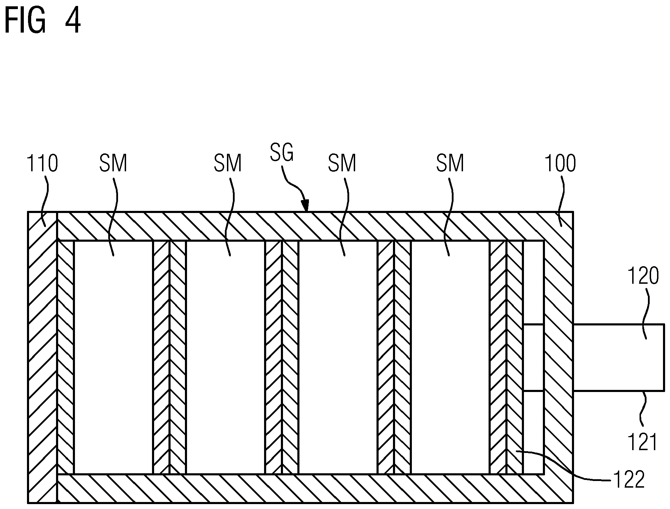

Mit den Submodulen SM gemäß den Figuren 2 und 3 lassen sich in sehr einfacher Weise Submodulgruppen SG bilden, indem die Submodule SM mit ihren außen liegenden Kühlkörpern 60 bzw. 80 aneinandergesetzt werden. Dies zeigt beispielhaft die Figur 4.

Um eine niederohmige Kontaktierung der Submodule SM zu gewährleisten sowie mechanische Schwingungen aufgrund der während des Betriebs der Submodule SM auftretenden Stromkräfte zu vermeiden oder zumindest soweit wie möglich zu reduzieren, wird es als vorteilhaft angesehen, wenn die Submodule SM der Submodulgruppe SG mittels einer Spanneinrichtung 100 aufeinander gepresst werden. Die Spanneinrichtung 100 besteht vorzugsweise aus einem elektrisch nicht leitenden Material, um einen Kurzschluss der Submodule SM zu vermeiden. Die Spanneinrichtung 100 kann beispielsweise durch einen Rahmen 110 und einen Stempel 120, beispielsweise in Form einer Schraube 121 und einer Pressplatte 122, gebildet sein.

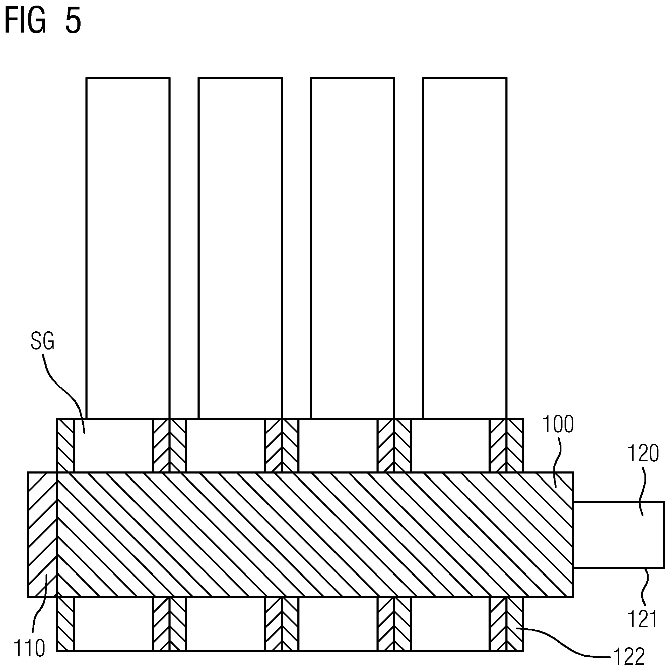

Die Figur 5 zeigt die Submodulgruppe SG mit der elektrisch isolierenden Spanneinrichtung 100 noch einmal in einer Sicht von der Seite. Es lässt sich erkennen, dass die Submodule SM der Submodulgruppe SG durch die Spanneinrichtung 100 fest aufeinander gedrückt werden.

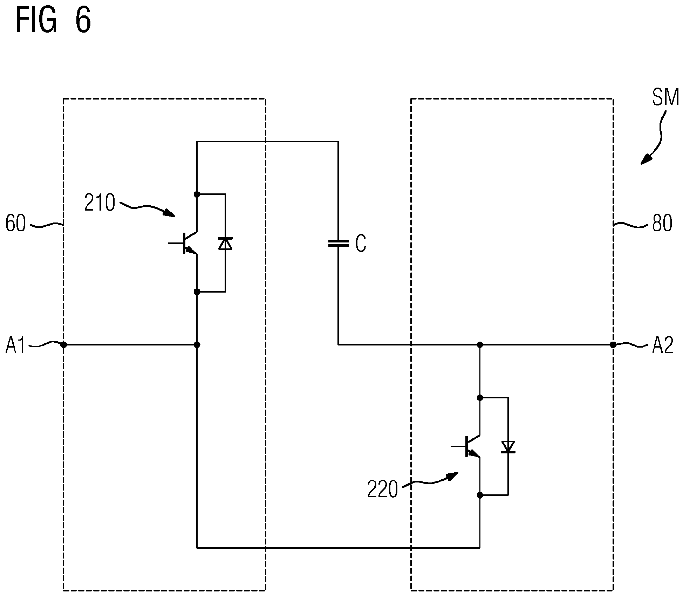

Die Figur 6 zeigt ein weiteres Ausführungsbeispiel für ein Submodul SM, das bei dem Multilevelumrichter 5 gemäß Figur 1 oder einem anderen Multilevelumrichter eingesetzt werden kann. Das Submodul SM weist zwei Schalter 210 und 220 auf, die jeweils an einem Kühlkörper 60 bzw. 80 des Submoduls SM befestigt sind. Die beiden Kühlkörper 60 und 80 üben darüber hinaus die Funktion stromtragender Modulanschlüsse A1 und A2 des Submoduls SM auf. Hierzu ist jeweils einer der Schalteranschlüsse der beiden Schalter 210 bzw. 220 mit dem jeweiligen Kühlkörper 60 und 80, auf dem der jeweilige Schalter befestigt ist, verbunden.

Mit dem Submodul SM gemäß Figur 6 lässt sich durch Aneinandersetzen der Kühlkörper 60 und 80 eine Submodulgruppe SG bilden, wie dies beispielhaft im Zusammenhang mit den Figuren 4 und 5 erläutert worden ist. Die obigen Ausführungen im Zusammenhang mit den Figuren 4 und 5 gelten für das Submodul SM also entsprechend.

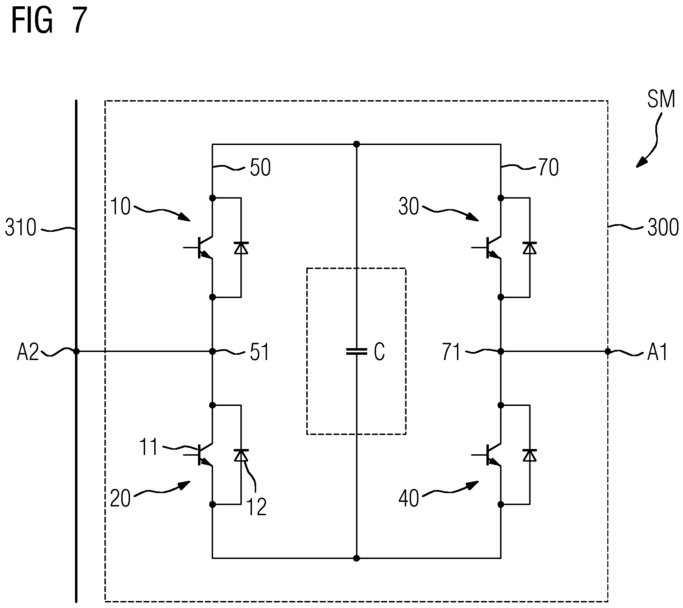

Die Figur 7 zeigt ein Ausführungsbeispiel für ein Submodul SM, das mit vier Schaltern 10, 20, 30 und 40 sowie einem Kondensator C ausgestattet ist. Die beiden Schalter 10 und 20 liegen elektrisch in Reihe und bilden eine Reihenschaltung 50. Die beiden Schalter 30 und 40 liegen elektrisch ebenfalls in Reihe und bilden eine Reihenschaltung 70.

Im Unterschied zu dem Ausführungsbeispiel gemäß den Figuren 2 und 3 ist bei dem Ausführungsbeispiel gemäß Figur 7 lediglich ein einziger Kühlkörper 300 vorgesehen, der zur Kühlung aller vier Schalter 10, 20, 30 und 40 dient. Ein Mittenanschluss 71 der Reihenschaltung 70 ist elektrisch mit dem Kühlkörper 300 verbunden, der aufgrund dieses Anschlusses einen stromtragenden Modulanschluss A1 des Submoduls SM bildet. Der andere stromtragende Modulanschluss A2 des Submoduls SM wird durch eine Elektrodenplatte 310 gebildet, die mit dem Mittenanschluss 51 der Reihenschaltung 50 in Verbindung steht.

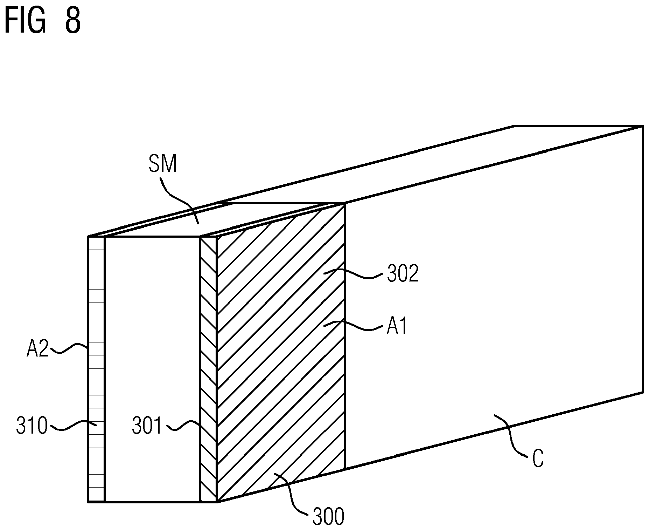

Die Figur 8 zeigt den mechanischen Aufbau des Submoduls SM gemäß Figur 7 in einer dreidimensionalen Sicht schräg von der Seite. Man erkennt den Kühlkörper 300, auf dessen Innenseite 301 die Schalter 10, 20, 30 und 40 montiert sind. Die Außenwand 302 des Kühlkörpers 300 bildet den stromtragenden Modulanschluss A1 des Submoduls SM.

Darüber hinaus lässt sich in der Figur 8 die Elektrodenplatte 310 erkennen, die elektrisch mit dem Mittenanschluss 51 der Reihenschaltung 50 verbunden ist. Es lässt sich erkennen, dass die Elektrodenplatte 310 plan ausgestaltet ist und parallel zur Außenwand 302 des Kühlkörpers 300 angeordnet ist. Aufgrund der planen Ausgestaltung der Außenwand 302 des Kühlkörpers 300 und der planen Ausgestaltung der Elektrodenplatte 310 ist es möglich, das Submodul SM mit gleichartigen Submodulen in Reihe zu schalten, indem diese kaskadiert nebeneinander angeordnet und aufeinander gedrückt werden.

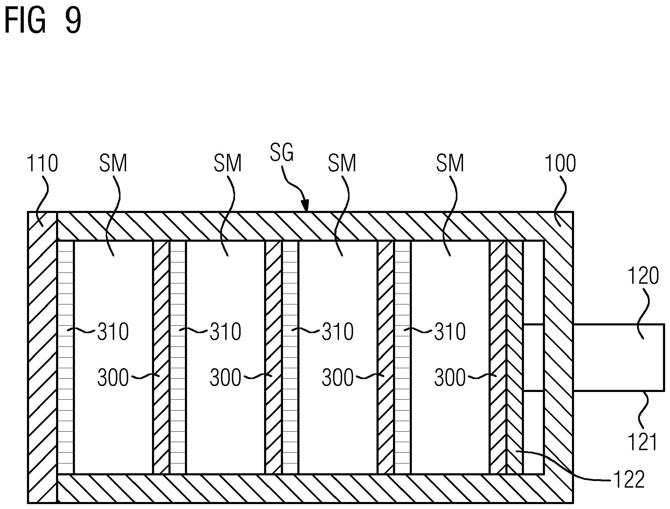

Die Figur 9 zeigt beispielhaft die Bildung einer Submodulgruppe SG durch ein Aneinandersetzten von Submodulen SM gemäß den Figuren 7 und 8. Es lässt sich erkennen, dass die Submodule SM derart aneinandergesetzt sind, dass die Elektrodenplatte 310 eines jeden innen liegenden Submoduls SM jeweils an dem Kühlkörper 300 eines benachbarten Submoduls SM und der Kühlkörper 300 eines jeden innen liegenden Submoduls SM an der Elektrodenplatte 310 eines anderen benachbarten Submoduls SM anliegt.

Um mechanische Schwingungen aufgrund der beim Betrieb des Submoduls SM auftretenden Stromkräfte zu vermeiden oder weitestgehend zu reduzieren, werden die Submodule SM vorzugsweise mittels einer Spanneinrichtung 100, die aus einem elektrisch isolierenden Material besteht, zusammengepresst, wie dies im Zusammenhang mit den Figuren 4 und 5 bereits oben erläutert worden ist. Die Spanneinrichtung 100 kann beispielsweise durch einen Rahmen 110 und einen Stempel 120 gebildet sein.

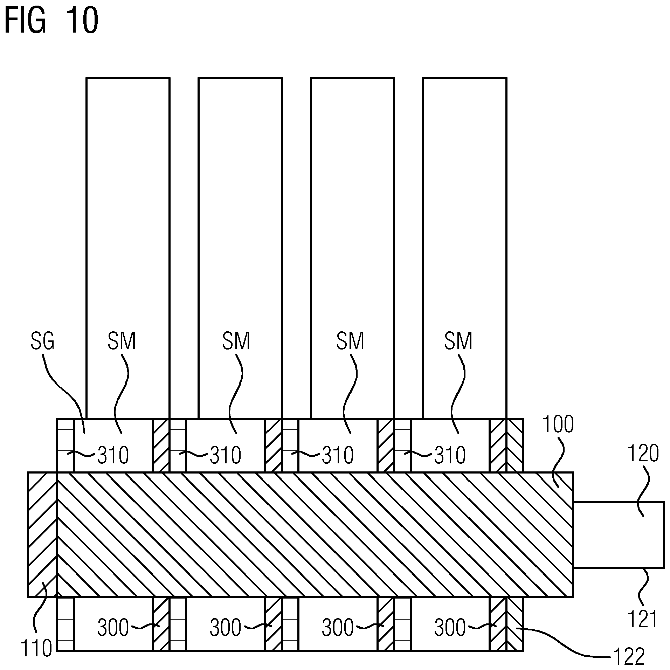

Die Figur 10 zeigt die Bildung der Submodulgruppe SG gemäß Figur 9 nochmals in einer Sicht von der Seite. Es lässt sich erkennen, dass die Submodule SM derart aneinandergesetzt sind, dass die Elektrodenplatte eines jeden innen liegenden Submoduls an einem Kühlkörper eines benachbarten Submoduls und der Kühlkörper eines jeden innen liegenden Submoduls an einer Elektrodenplatte eines anderen benachbarten Submoduls anliegt.

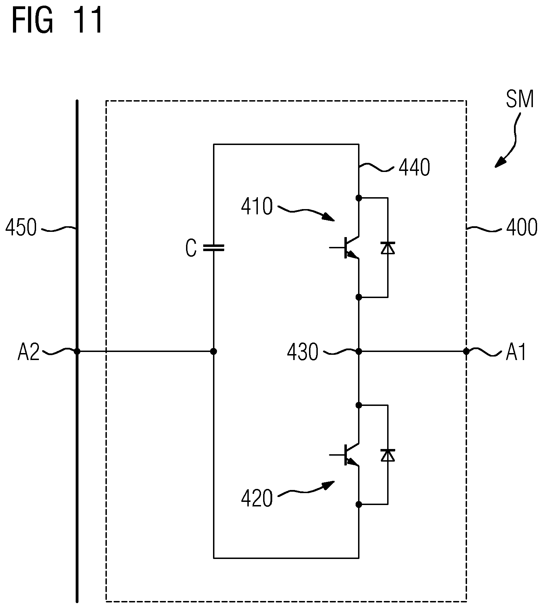

Die Figur 11 zeigt ein weiteres Ausführungsbeispiel für ein Submodul SM, das bei dem Multilevelumrichter 5 gemäß Figur 1 oder einem anderen Multilevelumrichter eingesetzt werden kann.

Das Submodul SM weist einen Kühlkörper 400 auf, der zum Kühlen der beiden Schalter 410 und 420 des Submoduls SM geeignet ist. Darüber hinaus dient der Kühlkörper 400 als stromtragender Modulanschluss A1 des Submoduls SM. Hierzu ist der Kühlkörper 400 elektrisch mit einem Mittenanschluss 430 der durch die beiden Schalter 410 und 420 gebildeten Reihenschaltung 440 verbunden.

Ein weiterer stromtragender äußerer Modulanschluss A2 des Submoduls SM wird durch eine Elektrodenplatte 450 gebildet, die elektrisch mit einem Kondensator C und dem Schalter 420 des Submoduls SM in Verbindung steht.

Der mechanische Aufbau des Submoduls SM gemäß Figur 11 entspricht vorzugsweise dem mechanischen Aufbau des Submoduls SM gemäß Figur 8, so dass auf die obigen Ausführungen verwiesen sei, die hier entsprechend gelten können. So ist es beispielsweise möglich, das Submodul SM gemäß Figur 11 zur Bildung einer Submodulgruppe SG zu nutzen, wie dies im Zusammenhang mit den Figuren 9 und 10 erläutert worden ist.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### Bezugszeichenliste

- 5: Multilevelumrichter
- 10: Schalter
- 11: schaltende Halbleiterkomponente
- 12: Diode
- 20: Schalter
- 30: Schalter
- 40: Schalter
- 50: Reihenschaltung
- 51: Mittenanschluss
- 60: Kühlkörper
- 61: Außenwand
- 62: Innenseite
- 70: Reihenschaltung
- 71: Mittenanschluss
- 80: Kühlkörper
- 81: Außenwand
- 82: Innenseite
- 100: Spanneinrichtung
- 110: Rahmen
- 120: Stempel
- 121: Schraube
- 122: Pressplatte
- 210: Schalter
- 220: Schalter
- 300: Kühlkörper
- 301: Innenseite
- 302: Außenwand
- 310: Elektrodenplatte
- 400: Kühlkörper
- 410: Schalter
- 420: Schalter
- 430: Mittenanschluss
- 440: Reihenschaltung
- 450: Elektrodenplatte

- A1: Modulanschluss
- A2: Modulanschluss
- C: Kondensator
- G5a: Gleichspannungsanschluss
- G5b: Gleichspannungsanschluss
- L: Induktivität
- SG: Submodulgruppe
- SM: Submodul
- W5: Wechselspannungsanschluss
- Z: Zwischenanschluss

## Patentansprüche

1. Multilevelumrichter (5) mit mindestens zwei in Reihe geschalteten Submodulen (SM), wobei jedes Submodul (SM) jeweils mindestens zwei Schalter (10, 20, 30, 40, 210, 220, 410, 420) und einen Kondensator (C) sowie zwei stromtragende äußere Modulanschlüsse (A1, A2) aufweist, wobei
mindestens ein Submodul mindestens einen außenliegenden Kühlkörper aufweist, der als stromtragender äußerer Modulanschluss dient,
**dadurch gekennzeichnet, dass**
- mindestens zwei benachbarte Submodule (SM) jeweils mindestens einen Kühlkörper (60, 80) aufweisen, der einen der stromtragenden äußeren Modulanschlüsse (A1, A2) des jeweiligen Submoduls bildet und an dem zumindest einer der Schalter (10, 20, 30, 40) des jeweiligen Submoduls (SM) zur Kühlung innenwandseitig montiert ist, und
- die Kühlkörper (60, 80) der mindestens zwei benachbarten Submodule (SM) außenwandseitig derart aneinander anliegen, dass deren Kühlkörper (60, 80) und damit die durch diese Kühlkörper (60, 80) gebildeten stromtragenden äußeren Modulanschlüsse (A1, A2) elektrisch miteinander verbunden sind.

2. Multilevelumrichter (5) nach einem der voranstehenden Ansprüche,
**dadurch gekennzeichnet, dass**
- zumindest zwei Submodule (SM) jeweils einen ersten und einen zweiten außenliegende Kühlkörper (60, 80) aufweisen, von denen der erste Kühlkörper (60) als erster stromtragender äußerer Modulanschluss (A1) und der zweite Kühlkörper (80) als zweiter stromtragender äußerer Modulanschluss (A2) des jeweiligen Submoduls (SM) dient, und
- der erste stromtragende äußere Modulanschluss (A1) eines der zumindest zwei Submodule (SM) mit dem zweiten stromtragenden äußeren Modulanschluss (A2) eines anderen der zumindest zwei Submodule (SM) elektrisch verbunden ist, und zwar durch mechanischen Kontakt zwischen dem ersten Kühlkörper (60) des einen der zumindest zwei Submodule (SM) und dem zweiten Kühlkörper (80) des anderen der zumindest zwei Submodule (SM).

3. Multilevelumrichter (5) nach einem der voranstehenden Ansprüche,
**dadurch gekennzeichnet, dass**
- zumindest eines der Submodule (SM) eine erste Reihenschaltung (50), eine zweite Reihenschaltung (70) und einen parallel zu den beiden Reihenschaltungen (50, 70) liegenden Kondensator (C) aufweist, wobei die erste Reihenschaltung (50) und die zweite Reihenschaltung (70) jeweils zwei elektrisch in Reihe liegende Schalter (10, 20, 30, 40) umfasst,
- die erste Reihenschaltung (50) an einem ersten Kühlkörper (60) des Submoduls (SM) und die zweite Reihenschaltung (70) an einem zweiten Kühlkörper (80) des Submoduls (SM) angebracht ist,
- ein Mittenanschluss (51) der ersten Reihenschaltung (50) elektrisch mit dem ersten Kühlkörper (60) verbunden ist und den ersten stromtragenden Modulanschluss (A1) des Submoduls (SM) bildet und
- ein Mittenanschluss (71) der zweiten Reihenschaltung (70) elektrisch mit dem zweiten Kühlkörper (80) verbunden ist und den zweiten stromtragenden Modulanschluss (A2) des Submoduls (SM) bildet.

4. Multilevelumrichter (5) nach Anspruch 3,
**dadurch gekennzeichnet, dass**
- zwei oder mehr Submodule (SM) jeweils eine erste Reihenschaltung (50) und eine zweite Reihenschaltung (70) mit jeweils zwei in Reihe liegenden Schaltern (10, 20, 30, 40) und jeweils einen parallel zu den beiden Reihenschaltungen (50, 70) liegenden Kondensator (C) aufweisen,
- die erste Reihenschaltung (50) an einem ersten Kühlkörper (60) des jeweiligen Submoduls (SM) und die zweite Reihenschaltung (70) an einem zweiten Kühlkörper (80) des jeweiligen Submoduls (SM) angebracht ist,
- ein Mittenanschluss (51) der ersten Reihenschaltung (50) jeweils elektrisch mit dem ersten Kühlkörper (60) des jeweiligen Submoduls (SM) verbunden ist und den ersten stromtragenden Modulanschluss (A1) des jeweiligen Submoduls (SM) bildet,
- ein Mittenanschluss (71) der zweiten Reihenschaltung (70) jeweils elektrisch mit dem zweiten Kühlkörper (80) des jeweiligen Submoduls (SM) verbunden ist und den zweiten stromtragenden Modulanschluss (A2) des jeweiligen Submoduls (SM) bildet, und
- die Submodule (SM) derart paarweise aneinander anliegen, dass der erste Kühlkörper (60) eines der Submodule (SM) an dem zweiten Kühlkörper (80) eines benachbarten Submoduls (SM) anliegt und mit diesem thermisch und elektrisch leitend verbunden ist.

5. Multilevelumrichter (5) nach einem der voranstehenden Ansprüche 1 oder2,
**dadurch gekennzeichnet, dass**
- zumindest eines der Submodule (SM) ein Halbbrückenmodul ist, das einen ersten Schalter (220, 420) und einen zweiten Schalter (210, 410) aufweist, wobei der zweite Schalter (210, 410) mit dem Kondensator (C) des Halbbrückenmoduls elektrisch in Reihe liegt und der erste Schalter (220, 420) zu dieser Reihenschaltung parallel liegt, und
- einer der beiden Schalteranschlüsse des ersten Schalters (220, 420) mit dem Kühlkörper oder einem der Kühlkörper (60, 80, 400) des Halbbrückenmoduls verbunden ist und einen der beiden stromtragenden äußeren Modulanschlüsse (A1, A2) des Halbbrückenmoduls bildet.

6. Multilevelumrichter (5) nach Anspruch 5,
**dadurch gekennzeichnet, dass**
- der Multilevelumrichter (5) zumindest zwei Halbbrückenmodule aufweist,
- der erste Schalter (220) der zumindest zwei Halbbrückenmodule mit einem ersten Kühlkörper (60) des jeweiligen Halbbrückenmoduls und der zweite Schalter (210) der zumindest zwei Halbbrückenmoduls mit einem zweiten Kühlkörper (80) des jeweiligen Halbbrückenmoduls verbunden ist,
- einer der beiden Schalteranschlüsse des ersten Schalters (220) der zumindest zwei Halbbrückenmodule elektrisch mit dem ersten Kühlkörper (60) des jeweiligen Halbbrückenmoduls verbunden ist und den ersten stromtragenden Modulanschluss (A1) des jeweiligen Halbbrückenmoduls bildet,
- der andere der beiden Schalteranschlüsse des ersten Schalters (220) der zumindest zwei Halbbrückenmodule elektrisch mit dem zweiten Kühlkörper (80) des jeweiligen Halbbrückenmoduls verbunden ist und den zweiten stromtragenden Modulanschluss (A2) des jeweiligen Halbbrückenmoduls bildet und
- die zumindest zwei Halbbrückenmodule paarweise derart aneinander anliegen, dass der erste Kühlkörper (60) eines der zumindest zwei Halbbrückenmodule an dem zweiten Kühlkörper (80) eines anderen der zumindest zwei Halbbrückenmodule anliegt und mit diesem elektrisch verbunden ist.

7. Multilevelumrichter (5) nach einem der voranstehenden Ansprüche,
**dadurch gekennzeichnet, dass**
- der erste und der zweite Kühlkörper (60, 80) zumindest zweier Submodule (SM) parallel zueinander angeordnet sind und stromtragende äußere Modulanschlussplatten bilden und
- die mindestens zwei Schalter (10, 20, 30, 40, 210, 220) des jeweiligen Submoduls (SM) räumlich in dem Bereich zwischen den zwei Modulanschlussplatten des jeweiligen Submoduls (SM) liegen.

8. Multilevelumrichter (5) nach einem der voranstehenden Ansprüche,
**dadurch gekennzeichnet, dass** eine Spanneinrichtung (100) vorhanden ist, die den ersten Kühlkörper (60) mindestens eines der Submodule (SM) auf einen zweiten Kühlkörper (80) eines benachbarten Submoduls (SM) presst.

9. Multilevelumrichter (5) nach Anspruch 1,
**dadurch gekennzeichnet, dass**
- zumindest eines der Submodule (SM) einen Kühlkörper aufweist, an dem die Schalter des jeweiligen Schaltmoduls montiert sind, und der Kühlkörper einen ersten stromtragenden äußeren Modulanschluss des Submoduls bildet, und
- das Submodul eine Elektrodenplatte aufweist, die beabstandet zu dem Kühlkörper des Submoduls angeordnet ist und einen zweiten stromtragenden äußeren Modulanschluss des Submoduls bildet.

10. Multilevelumrichter nach Anspruch 9,
**dadurch gekennzeichnet, dass**
- zumindest zwei Submodule jeweils einen Kühlkörper (300, 400) aufweisen, an dem die Schalter (10, 20, 30, 40, 410, 420) des jeweiligen Schaltmoduls montiert sind, und der Kühlkörper (300, 400) einen ersten stromtragenden äußeren Modulanschluss (A1) des jeweiligen Submoduls (SM) bildet,
- die zumindest zwei Submodule (SM) jeweils eine Elektrodenplatte (310, 450) aufweisen, die beabstandet zu dem Kühlkörper (300, 400) des jeweiligen Submoduls (SM) angeordnet ist und einen zweiten stromtragenden äußeren Modulanschluss (A2) des jeweiligen Submoduls (SM) bildet, und
- der erste stromtragende äußere Modulanschluss (A1) eines der zumindest zwei Submodule (SM) mit dem zweiten stromtragenden äußeren Modulanschluss (A2) eines anderen der zumindest zwei Submodule (SM) elektrisch verbunden ist, und zwar durch mechanischen Kontakt zwischen dem Kühlkörper (300, 400) des einen der zumindest zwei Submodule (SM) mit der Elektrodenplatte (310, 450) des anderen der zumindest zwei Submodule (SM) .

11. Multilevelumrichter (5) nach Anspruch 10,
**dadurch gekennzeichnet, dass**
- der Kühlkörper (300, 400) und die Elektrodenplatte (310, 450) bei den zumindest zwei Submodulen (SM) jeweils parallel zueinander angeordnet sind und stromtragende äußere Modulanschlussplatten des jeweiligen Submoduls (SM) bilden und
- die mindestens zwei Schalter (10, 20, 30, 40, 410, 420) eines jeden der zumindest zwei Submodule (SM) jeweils räumlich in dem Bereich zwischen den beiden stromtragenden äußeren Modulanschlussplatten liegen.

12. Multilevelumrichter (5) nach Anspruch 10,
**dadurch gekennzeichnet, dass** eine Spanneinrichtung (100) vorhanden ist, die den Kühlkörper (300, 400) mindestens eines der Submodule (SM) auf eine Elektrodenplatte (310, 450) eines benachbarten Submoduls (SM) presst.

13. Submodul (SM) für einen Multilevelumrichter (5) nach einem der voranstehenden Ansprüche, wobei das Submodul (SM) mindestens zwei Schalter (10, 20, 30, 40, 210, 220, 410, 420), einen Kondensator (C) sowie zwei stromtragende äußere Modulanschlüsse(A1, A2) aufweist,
**dadurch gekennzeichnet, dass** mindestens ein außenliegender Kühlkörper (60, 80, 300, 400) des Submoduls (SM) als stromtragender äußerer Modulanschluss (A1, A2) dient.

## Claims

1. Multilevel converter (5) comprising at least two submodules (SM) connected in series, wherein each submodule (SM) has in each case at least two switches (10, 20, 30, 40, 210, 220, 410, 420) and a capacitor (C) and two current-carrying external module terminals (A1, A2), wherein
at least one submodule has at least one outer heat sink that serves as a current-carrying external module terminal, **characterized in that**
- at least two adjacent submodules (SM) have in each case at least one heat sink (60, 80) which forms one of the current-carrying external module terminals (A1, A2) of the respective submodule and on which at least one of the switches (10, 20, 30, 40) of the respective submodule (SM) is mounted on the inner wall side for cooling purposes, and
- the heat sinks (60, 80) of the at least two adjacent submodules (SM) bear against one another on the outer wall side in such a way that the heat sinks (60, 80) thereof and thus the current-carrying external module terminals (A1, A2) formed by said heat sinks (60, 80) are electrically connected to one another.

2. Multilevel converter (5) according to any of the preceding claims,
**characterized in that**
- at least two submodules (SM) have in each case a first and a second outer heat sink (60, 80), of which the first heat sink (60) serves as a first current-carrying external module terminal (A1) and the second heat sink (80) serves as a second current-carrying external module terminal (A2) of the respective submodule (SM) and
- the first current-carrying external module terminal (A1) of one of the at least two submodules (SM) is electrically connected to the second current-carrying external module terminal (A2) of another of the at least two submodules (SM), specifically by mechanical contact between the first heat sink (60) of said one of the at least two submodules (SM) and the second heat sink (80) of the other of the at least two submodules (SM).

3. Multilevel converter (5) according to any of the preceding claims,
**characterized in that**
- at least one of the submodules (SM) has a first series circuit (50), a second series circuit (70) and a capacitor (C) connected in parallel with the two series circuits (50, 70), wherein the first series circuit (50) and the second series circuit (70) comprise in each case two switches (10, 20, 30, 40) electrically connected in series,
- the first series circuit (50) is fitted to a first heat sink (60) of the submodule (SM) and the second series circuit (70) is fitted to a second heat sink (80) of the submodule (SM),
- a center terminal (51) of the first series circuit (50) is electrically connected to the first heat sink (60) and forms the first current-carrying module terminal (A1) of the submodule (SM), and
- a center terminal (71) of the second series circuit (70) is electrically connected to the second heat sink (80) and forms the second current-carrying module terminal (A2) of the submodule (SM).

4. Multilevel converter (5) according to Claim 3,
**characterized in that**
- two or more submodules (SM) have in each case a first series circuit (50) and a second series circuit (70) having in each case two series-connected switches (10, 20, 30, 40) and in each case a capacitor (C) connected in parallel with the two series circuits (50, 70),
- the first series circuit (50) is fitted to a first heat sink (60) of the respective submodule (SM) and the second series circuit (70) is fitted to a second heat sink (80) of the respective submodule (SM),
- a center terminal (51) of the first series circuit (50) is in each case electrically connected to the first heat sink (60) of the respective submodule (SM) and forms the first current-carrying module terminal (A1) of the respective submodule (SM),
- a center terminal (71) of the second series circuit (70) is in each case electrically connected to the second heat sink (80) of the respective submodule (SM) and forms the second current-carrying module terminal (A2) of the respective submodule (SM),
- the submodules (SM) bear against one another in pairs in such a way that the first heat sink (60) of one of the submodules (SM) bears against the second heat sink (80) of an adjacent submodule (SM) and is thermally and electrically conductively connected thereto.

5. Multilevel converter (5) according to any of the preceding Claims 1 and 2,
**characterized in that**
- at least one of the submodules (SM) is a half-bridge module having a first switch (220, 420) and a second switch (210, 410), wherein the second switch (210, 410) is electrically connected in series with the capacitor (C) of the half-bridge module and the first switch (220, 420) is connected in parallel with this series circuit, and
- one of the two switch terminals of the first switch (220, 420) is connected to the heat sink or one of the heat sinks (60, 80, 400) of the half-bridge module and forms one of the two current-carrying external module terminals (A1, A2) of the half-bridge module.

6. Multilevel converter (5) according to Claim 5,
**characterized in that**
- the multilevel converter (5) has at least two half-bridge modules,
- the first switch (220) of the at least two half-bridge modules is connected to a first heat sink (60) of the respective half-bridge module and the second switch (210) of the at least two half-bridge modules is connected to a second heat sink (80) of the respective half-bridge module,
- one of the two switch terminals of the first switch (220) of the at least two half-bridge modules is electrically connected to the first heat sink (60) of the respective half-bridge module and forms the first current-carrying module terminal (A1) of the respective half-bridge module,
- the other of the two switch terminals of the first switch (220) of the at least two half-bridge modules is electrically connected to the second heat sink (80) of the respective half-bridge module and forms the second current-carrying module terminal (A2) of the respective half-bridge module, and
- the at least two half-bridge modules bear against one another in pairs in such a way that the first heat sink (60) of one of the at least two half-bridge modules bears against the second heat sink (80) of another of the at least two half-bridge modules and is electrically connected thereto.

7. Multilevel converter (5) according to any of the preceding claims,
**characterized in that**
- the first and second heat sinks (60, 80) of at least two submodules (SM) are arranged parallel to one another and form current-carrying external module terminal plates, and
- the at least two switches (10, 20, 30, 40, 210, 220) of the respective submodule (SM) lie spatially in the region between the two module terminal plates of the respective submodule (SM).

8. Multilevel converter (5) according to any of the preceding claims,
**characterized in that**
a clamping device (100) is present, which presses the first heat sink (60) of at least one of the submodules (SM) onto a second heat sink (80) of an adjacent submodule (SM).

9. Multilevel converter (5) according to Claim 1, **characterized in that**
- at least one of the submodules (SM) has a heat sink on which the switches of the respective switching module are mounted, and the heat sink forms a first current-carrying external module terminal of the submodule, and
- the submodule has an electrode plate that is arranged at a distance from the heat sink of the submodule and forms a second current-carrying external module terminal of the submodule.

10. Multilevel converter according to Claim 9,
**characterized in that**
- at least two submodules have in each case a heat sink (300, 400) on which the switches (10, 20, 30, 40, 410, 420) of the respective switching module are mounted, and the heat sink (300, 400) forms a first current-carrying external module terminal (A1) of the respective submodule (SM),
- the at least two submodules (SM) have in each case an electrode plate (310, 450) that is arranged at a distance from the heat sink (300, 400) of the respective submodule (SM) and forms a second current-carrying external module terminal (A2) of the respective submodule (SM), and
- the first current-carrying external module terminal (A1) of one of the at least two submodules (SM) is electrically connected to the second current-carrying external module terminal (A2) of another of the at least two submodules (SM), specifically by mechanical contact between the heat sink (300, 400) of said one of the at least two submodules (SM) and the electrode plate (310, 450) of the other of the at least two submodules (SM).

11. Multilevel converter (5) according to Claim 10,
**characterized in that**
- the heat sink (300, 400) and the electrode plate (310, 450) in the at least two submodules (SM) are arranged in each case parallel to one another and form current-carrying external module terminal plates of the respective submodule (SM), and
- the at least two switches (10, 20, 30, 40, 410, 420) of each of the at least two submodules (SM) in each case lie spatially in the region between the two current-carrying external module terminal plates.

12. Multilevel converter (5) according to Claim 10,
**characterized in that**
a clamping device (100) is present, which presses the heat sink (300, 400) of at least one of the submodules (SM) onto an electrode plate (310, 450) of an adjacent submodule (SM).

13. Submodule (SM) for a multilevel converter (5) according to any of the preceding claims, wherein the submodule (SM) has at least two switches (10, 20, 30, 40, 210, 220, 410, 420), a capacitor (C) and two current-carrying external module terminals (A1, A2),
**characterized in that**
at least one outer heat sink (60, 80, 300, 400) of the submodule (SM) serves as a current-carrying external module terminal (A1, A2).

## Revendications

1. Convertisseur (5) à plusieurs niveaux, ayant au moins deux sous-modules (SM) montés en série, chaque sous-module (SM) ayant, respectivement, au moins deux interrupteurs (10, 20, 30, 40, 210, 220, 410, 420) et un condensateur (C), ainsi que deux bornes (A1, A2) extérieures de module portant le courant, dans lequel
au moins un sous-module a au moins un refroidisseur, qui se trouve à l'extérieur et qui sert de borne extérieure de module portant le courant,
**caractérisé en ce que**
- au moins deux sous-modules (SM) voisins ont chacun au moins un refroidisseur (60, 80), qui forme l'une des bornes (A1, A2) extérieures de module portant le courant du sous-module respectif et qui est monté du côté de la paroi intérieure pour le refroidissement sur le au moins un des interrupteurs (10, 20, 30, 40) du sous-module (SM) respectif, et
- les refroidisseurs (60, 80) des au moins deux sous-modules (SM) voisins s'appliquent l'un à l'autre du côté de la paroi extérieure, de manière à relier électriquement entre eux le refroidisseur (60, 80) et ainsi les bornes (A1, A2) extérieures de module portant le courant formé par ces refroidisseurs (60, 80).

2. Convertisseur (5) à plusieurs niveaux suivant l'une des revendications précédentes,
**caractérisé en ce que**
- au moins deus sous-modules (SM) ont chacun un premier et un deuxième refroidisseurs (60, 80) se trouvant à l'extérieur, dont le premier (60) sert de première borne (A1) extérieure de module portant le courant et le deuxième (80) de deuxième borne (A2) extérieure portant le courant du sous-module (SM) respectif, et
- la première borne (A1) extérieure de module portant le courant de l'un des au moins deux sous-modules (SM) est reliée électriquement à la deuxième borne (A2) extérieure de module portant le courant d'un autre des au moins deux sous-modules (SM) et, de fait, par contact mécanique entre le premier refroidisseur (60) du un des au moins deux sous-modules (SM) et le deuxième refroidisseur (80) de l'autre des au moins deux sous-modules (SM).

3. Convertisseur (5) à plusieurs niveaux suivant l'une des revendications précédentes,
**caractérisé en ce que**
- au moins l'un des sous-modules (SM) a un premier montage (50) en série, un deuxième montage (70) en série et un condensateur (C) en parallèle aux deux montages (50, 70) en série, le premier montage (50) en série et le deuxième montage (70) en série comprenant chacun deux interrupteurs (10, 20, 30, 40) en série électriquement,
- le premier montage (50) en série est mis sur un premier refroidisseur (60) du sous-module (SM) et le deuxième montage (70) en série sur un deuxième refroidisseur (80) du sous-module (SM),
- une borne (51) médiane du premier montage (50) en série est reliée électriquement au premier refroidisseur (60) et forme la première borne (A1) de module portant le courant du sous-module (SM) et
- une borne (71) médiane du deuxième montage (70) en série est reliée électriquement au deuxième refroidisseur (80) et forme la deuxième borne (A2) de module portant le courant du sous-module (SM).

4. Convertisseur (5) à plusieurs niveaux suivant la revendication 3,
**caractérisé en ce que**
- deux ou plus de deux sous-modules (SM) ont chacun un premier montage (50) en série et un deuxième montage (70) en série ayant, respectivement, deux interrupteurs (10, 20, 30, 40) en série et, respectivement, un condensateur (C) en parallèle avec les deux montages (50, 70) en série,
- le premier montage (50) en série est mis sur un premier refroidisseur (60) du sous-module (SM) respectif et le deuxième montage (70) en série sur un deuxième refroidisseur (80) du sous-module (SM) respectif,
- une borne (51) médiane du premier montage (50) en série est reliée, respectivement, électriquement au premier refroidisseur (60) du sous-module (SM) respectif et forme la première borne (A1) de module portant le courant du sous-module (SM) respectif,
- une borne (71) médiane du deuxième montage (7) en série est reliée, respectivement, électriquement au deuxième refroidisseur (80) du sous-module (SM) respectif et forme la deuxième borne (A2) de module portant le courant du sous-module (SM) respectif, et
- les sous-modules (SM) s'appliquent l'un à l'autre par paire, de manière à ce que le premier refroidisseur (60) de l'un des sous-modules (SM) s'applique au deuxième refroidisseur (80) d'un sous-module (SM) voisin et y soit relié thermiquement et d'une manière conductrice de l'électricité.

5. Convertisseur (5) à plusieurs niveaux suivant l'une des revendications 1 ou 2 précédentes,
**caractérisé en ce que**
- au moins l'un des sous-modules (SM) est un module en demi-pont, qui a un premier interrupteur (220, 420) et un deuxième interrupteur (210, 410), le deuxième interrupteur (210, 410) étant monté en série électriquement avec le condensateur (C) du module en demi-pont et le premier interrupteur (220, 420) étant en parallèle avec ce montage en série, et
- l'une des deux bornes du premier interrupteur (220, 420) est reliée au refroidisseur ou à l'un des refroidisseurs (60, 80, 400) du module en demi-pont et forme l'une des deux bornes (A1, A2) extérieures de module portant le courant du module en demi-pont.

6. Convertisseur (5) à plusieurs niveaux suivant la revendication 5,
**caractérisé en ce que**
- le convertisseur (5) à plusieurs niveaux a au moins deux modules en demi-pont,
- le premier interrupteur (220) des au moins deux modules en demi-pont est relié à un premier refroidisseur (60) du module en demi-pont respectif et le deuxième interrupteur (210) des au moins deux modules en demi-pont est relié à un deuxième refroidisseur (80) du module en demi-pont respectif,
- l'une des deux bornes du premier interrupteur (220) des au moins deux modules en demi-pont est reliée électriquement au premier refroidisseur (60) du module en demi-pont respectif et forme la première borne (A1) de module portant le courant du module en demi-pont respectif,
- l'autre des deux bornes du premier interrupteur (220) des au moins deux modules à demi-pont est reliée électriquement au deuxième refroidisseur (80) du module en demi-pont respectif et forme la deuxième borne (A2) de module portant le courant du module en demi-pont respectif et
- les au moins deux modules en demi-pont s'appliquent l'un à l'autre par paire, de manière à ce que le premier refroidisseur (60) de l'un des au moins deux modules en demi-pont s'applique au deuxième refroidisseur (80) d'un autre des au moins deux modules en demi-pont et y soit relié électriquement.

7. Convertisseur (5) à plusieurs niveau suivant l'une des revendications précédentes,
**caractérisé en ce que**
- le premier et le deuxième refroidisseurs (60, 80) d'au moins deux sous-modules (SM) sont montés en parallèle l'un à l'autre et forment des plaques extérieures de borne de module portant le courant et
- les au moins deux interrupteurs (10, 20, 30, 40, 210, 220) du sous-module (SM) respectif se trouvent dans l'espace dans la région comprise entre les deux plaques de connexion de module du sous-module (SM) respectif.

8. Convertisseur (5) à plusieurs niveau suivant l'une des revendications précédentes,
**caractérisé en ce qu'**
il est prévu un dispositif (100) de serrage, qui presse le premier refroidisseur (60) d'au moins l'un des sous-modules (SM) sur un deuxième refroidisseur (80) d'un sous-module (SM) voisin.

9. Convertisseur (5) à plusieurs niveau suivant la revendication 1,
**caractérisé en ce que**
- au moins l'un des sous-modules (SM) a un refroidisseur sur lequel sont montés les interrupteurs des modules de coupure respectifs et le refroidisseur forme une première borne extérieure de module portant le courant du sous-module, et
- le sous-module a une plaque d'électrode, qui est disposée à distance du refroidisseur du sous-module et qui forme une borne extérieure de module portant le courant du sous-module.

10. Convertisseur (5) à plusieurs niveau suivant la revendication 9,
**caractérisé en ce que**
- au moins deux sous-modules ont chacun un refroidisseur (300, 400) sur lequel sont montés les interrupteurs (10, 20, 30, 40, 410, 420) du module de coupure respectif et le refroidisseur (300, 400) forme une première borne (A1) extérieure de module portant le courant du sous-module (SM) respectif,
- les au moins deux sous-modules (SM) ont chacun une plaque (310, 450) d'électrode, qui est disposée à distance du refroidisseur (300, 400) du sous-module (SM) respectif et qui forme une deuxième borne (A2) extérieure de module portant le courant du sous-module (SM) respectif, et
- la première borne (A1) extérieure de module portant le courant de l'un des au moins deux sous-modules (SM) est reliée électriquement à la deuxième borne (A2) extérieure de module portant le courant d'un autre des au moins deux sous-modules (SM) et, de fait, par contact mécanique entre le refroidisseur (300, 400) de l'un des au moins deux sous-modules (SM) avec la plaque (310, 450) d'électrode de l'autre des au moins deux sous-modules (SM).

11. Convertisseur (5) à plusieurs niveau suivant la revendication 10,
**caractérisé en ce que**
- le refroidisseur (300, 400) et la plaque (310, 450) d'électrode sont, pour les au moins deux sous-modules (SM), disposés, respectivement, parallèlement l'un à l'autre et forment des plaques extérieures de connexion de module portant le courant du sous-module (SM) respectif et
- les au moins deux interrupteurs (10, 20, 30, 40, 410, 420) de chacun des au moins deux sous-modules (SM) se trouvent, respectivement, dans l'espace dans la région comprise entre les deux plaques extérieures de connexion de module portant le courant.

12. Convertisseur (5) à plusieurs niveau suivant la revendication 10,
**caractérisé en ce qu'**
il y a un dispositif (100) de serrage, qui presse les refroidisseurs (300, 400) d'au moins l'un des sous-modules (SM) sur une plaque (310, 450) d'électrode d'un sous-module (SM) voisin.

13. Sous-module (SM) d'un convertisseur (5) à plusieurs niveaux suivant l'une des revendications précédentes, dans lequel le sous-module (SM) a au moins deux interrupteurs (10, 20, 30, 40, 210, 220, 410, 420), un condensateur (C), ainsi que deux bornes (A1, A2) extérieures de module portant le courant,
**caractérisé en ce qu'**
au moins un refroidisseur (60, 80, 300, 400), se trouvant à l'extérieur du sous-module (SM), sert de borne (A1, A2) extérieure de module portant le courant.
